# EUROPEAN PATENT APPLICATION

(11) **EP 4 794 463 A1**
(43) Date of publication of application: **19.08.2026**
(21) Application number: 26151321.2
(22) Date of filing: 12.01.2026
(51) Int. Cl.: H05K 7/20

(54) **COOLING MODULE**

(30) Priority: 12.02.2025 GB 202502081
(71) Applicant: Rolls-Royce plc, London N1 9FX (GB)
(72) Inventor: Gajanayake, Chandana, Derby, DE24 8BJ (GB); Wang, Shuai, Derby, DE24 8BJ (GB); Kharbanda, Pranshu, Derby, DE24 8BJ (GB); Molligoda, Devinda, Derby, DE24 8BJ (GB)
(74) Representative: Rolls-Royce plc

(57) **Abstract**

This disclosure relates to cooling modules for power electronics converters. Example embodiments include a cooling module (100) for a power electronics converter, comprising: first face (101) having a cooling liquid inlet (102); an opposing second face (103) having a cooling liquid outlet (104); a plurality of side walls (105a-d) extending between the first and second faces (101, 103), each side wall (105a-d) being configured for cooling a semiconductor switching device (106₁₋₆) of the power electronics converter; and a helical cooling channel (107) extending through the cooling module between the cooling liquid inlet (102) and the cooling liquid outlet (104).

## Description

### CROSS REFERENCE TO RELATED APPLICATIONS

This represents the first application directed towards the subject-matter.

### FIELD

This disclosure relates to cooling modules for power electronics converters.

### BACKGROUND

Power electronics converters are key components in systems providing electrical power to, or deriving electrical power from, electrical machines. In hybrid and full electric aircraft systems, power electronics converters can be used for conversion between AC and DC to extract electrical power from, and provide electrical power to, AC electric machines as well as for DC:DC conversion to and from a DC electrical bus and a DC electrical storage battery.

When a power electronics converter operates, losses are incurred as a result of non-ideal switching devices and through passive devices. Semiconductor switches will incur conductive losses and switching losses, while other components such as inductors will have core losses and ohmic losses. Conduction losses for each switching device will depend on the on-state device resistance (which is temperature dependent), the current through the device and the modulation index of the converter operation. Switching losses will depend on the power converter switching frequency, device turn-on energy and turn-off energy (both of which are temperature dependent). In the design stage, a power electronics converter can be optimized to have low losses but a large power loss is inevitable when designing a compact and high-power density converter. It is vital therefore to provide cooling of the converter by removing heat energy. Without adequate cooling, premature failing of components or thermal failure of switches may occur over time, once the junction temperature exceeds its maximum allowed limit. This will put the power converter out of service.

Current power converter designs may use finned heat sinks, using natural or forced air cooling, or cold plates with liquid cooling to cool the semiconductor switches. For passive devices such as inductors and capacitors, either natural air cooling or forced air cooling may be used. Where air cooling is used, the power density (both gravimetric and volumetric) of the converter will tend to drop as this involves bulky heat sinks with additional components. In such systems, oversized conductors may be used to reduce current densities, and extra devices (such as MOSFETs) may be used in parallel to reduce losses further, but at the expense of making the system bigger and heavier. Furthermore, the addition of more components increases the volume and space utilization, which may not be feasible with limitations present in aerospace applications. Additionally, the ineffectiveness of cold plates to cool large and bulky components may also cause the development of hotspots within the component, based on the orientation of the cooling to the cold plate.

### SUMMARY

According to a first aspect there is provided a cooling module for a power electronics converter, comprising:
a first face having a cooling liquid inlet;
an opposing second face having a cooling liquid outlet;
a plurality of side walls extending between the first and second faces, each side wall being configured for cooling a semiconductor switching device of the power electronics converter; and
a helical cooling channel extending through the cooling module between the cooling liquid inlet and the cooling liquid outlet.

The helical cooling channel may pass along each of the plurality of side walls.

The cooling module may comprise a parallel cooling channel extending from the cooling liquid outlet across one of the plurality of side walls and connecting to the helical cooling channel. A diameter of the parallel cooling channel may be smaller than a diameter of the helical cooling channel.

Where the helical cooling channel is a first helical cooling channel, the cooling liquid inlet a first cooling liquid inlet and the cooling liquid outlet a first cooling liquid outlet, the first face may comprise a second cooling liquid outlet, the second face a second cooling liquid inlet, the cooling module comprising a second helical cooling channel extending through the cooling module between the second cooling liquid inlet and the second cooling liquid outlet. The first and second helical cooling channels may each pass along each of the plurality of side walls.

The first liquid cooling inlet may be at an opposing corner of the first face to the second liquid cooling outlet and the first liquid cooling outlet may be at an opposing corner of the second face to the second liquid cooling inlet.

The first and second faces may be generally rectangular in shape and the cooling module may comprise four side walls.

The cooling module may comprise a central bore between the first and second faces for cooling an inductor of the power electronics converter.

The cooling module may further comprise a central cooling channel passing through the central bore.

The cooling module may be composed of an aluminium alloy.

According to a second aspect there is provided a modular cooling assembly for a power electronics converter, the modular cooling assembly comprising a plurality of cooling modules according to the first aspect connected together such that a combined helical liquid cooling channel extends through each of the helical liquid cooling channels of the plurality of cooling modules.

According to a third aspect there is provided a power electronics converter assembly comprising:
a cooling module according to the first aspect; and
one or more semiconductor switches mounted to each of the plurality of side walls of the cooling module.

The cooling module may comprise a central bore between the first and second faces, the assembly comprising inductor components mounted within the central bore. The cooling module may comprise a central cooling channel passing through the central bore.

### BRIEF DESCRIPTION OF THE DRAWINGS

Embodiments will now be described by way of example only with reference to the accompanying drawings, in which:
FIG. 1 is a drawing of an example cooling module for a power electronics converter;
FIG. 2 is a schematic side view drawing of helical cooling channels in the cooling module of FIG. 1;
FIGs. 3a, 3b and 3c are drawings of example cooling modules prior to being connected to form a cooling assembly;
FIG. 4 is a drawing of the cooling modules of FIGs. 3a-c connected together to form a cooling assembly;
FIG. 5 is a schematic side view drawing of helical cooling channels in the cooling assembly of FIG. 4;
FIG. 6 is a further drawing of the cooling assembly of FIG. 4, indicating sections A-A, B-B and C-C through the cooling assembly;
FIG. 7 is a sectional drawing through C-C of the cooling assembly of FIG. 6;
FIG. 8 is a sectional drawing through A-A of the cooling assembly of FIG. 6; and
FIG. 9 is a sectional drawing through B-B of the cooling assembly of FIG. 6.

### DETAILED DESCRIPTION

The present disclosure describes a thermal management design for power electronics converter components, including power semiconductor devices and inductors. The design is a highly integrated high-density cooling concept that can enhance cooling efficiencies and reduce the converter volume and weight for a given power loss. Liquid cooling is utilized, in which a liquid coolant passes through channels of a cooling module in a helical pattern that allows side walls of the cooling module, on which semiconductor switching devices can be mounted, to be cooled. A central bore of the cooling module may allow for an inductor to be mounted within the cooling module and also cooled. The design of the cooling module is modular so that multiple modules can be stacked to incorporate multiple sets of components. The cooling module may have redundancy built into the design by incorporating more than one cooling channel.

The proposed cooling module can be used in applications where a high-power density is required, such as for power electronics converter assemblies in hybrid and full electric aircraft designs.

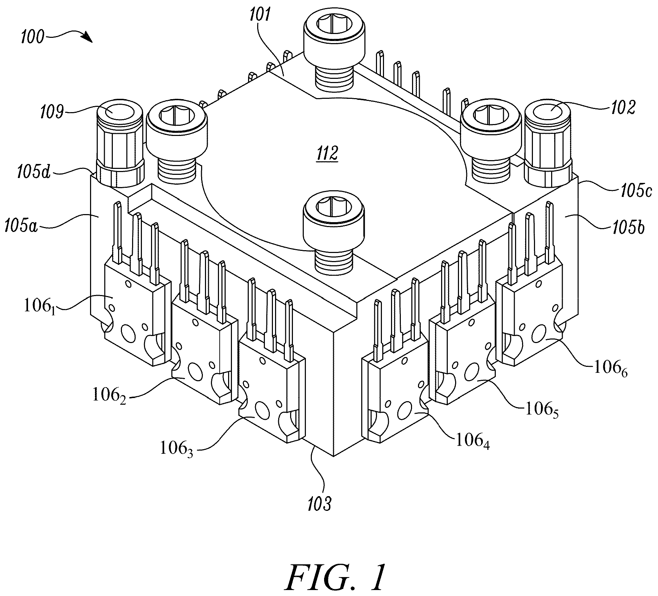

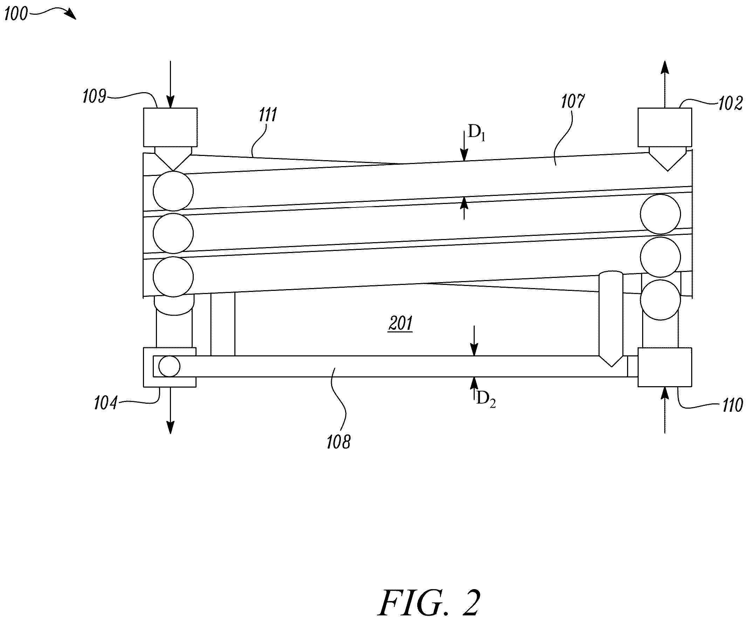

FIG. 1 illustrates an example cooling module 100 for a power electronics converter. The cooling module 100 comprises a first face 101 having a first cooling liquid inlet 102. A second opposing face 103 has a first cooling liquid outlet 104 (shown in FIG. 2). A plurality of side walls 105a-d extend between the first and second faces 101, 103. Each side wall 105a-d is configured for cooling a semiconductor switching device 106₁₋₆ of the power electronics converter that is mounted thereon. In the illustrated example, each of the side walls 105a-d accommodates mounting of three semiconductor switches 106₁₋₆, which may for example be MOSFETs. The illustrated example cooling module 100 has four side walls 105a-d, with the first and second faces 101, 103 generally rectangular or square in shape. Alternative configurations may have a different number of side walls, for example three or more, with faces that may be triangular, pentagonal, hexagonal etc. in shape. In a general aspect, the first and second faces 101, 103 may have the general shape of a regular polygon and the cooling module 100 may have three or more side walls.

The cooling module 100 has a helical cooling channel 107 extending through the cooling module 100 between the first cooling liquid inlet 102 and the first cooling liquid outlet 104, as shown in FIG. 2. In use, cooling liquid enters the first cooling liquid inlet 102 and passes through the helical cooling channel 107 along the side walls 105a-d. In the example illustrated in FIG. 2, the first helical cooling channel 107 passes along each of the plurality of side walls 105a-d and cooling liquid exits the first helical cooling channel 107 through the first liquid cooling outlet 104. In this case, the inlet 102 and outlet 104 are positioned at opposing corners of the first and second faces 101, 103 respectively. A second helical cooling channel 111 may also be provided, which also extends along each of the side walls 105a-d. A second cooling liquid inlet 110 is provided on the second face 103 and a second cooling liquid outlet 109 is provided on the first face 101. Cooling flows through the cooling module 100 may therefore be in opposing directions through the first and second helical cooling channels 107, 111, which can aid in providing a more uniform cooling through the thickness of the cooling module 100. In alternative arrangements the inlets of both helical cooling channels 107, 111 may be on the same face and the outlets on the same opposing face. The use of the terms inlet and outlet herein are not therefore intended to imply any restrictions on use or orientation of the cooling module 100 and may be used interchangeably, given that both inlets and outlets may be of similar construction.

The cooling module 100 may be primarily composed of a metal with a high thermal conductivity such as an aluminium alloy, with cooling channels 107, 111 machined into the cooling module 100. The cooling module 100 may alternatively be formed at least partly through additive layer manufacturing, given the complex cooling channels required through the cooling module 100.

A central bore 112 may be provided in the cooling module 100, extending between the first and second faces 101, 103. The central bore 112 may accommodate an inductor of the power electronics converter. The inductor core and wiring may be embedded within the central bore 112 in a thermally conductive resin material. The semiconductor switching devices 106₁₋₆ may be mounted on the side walls 105a-d with a thermally conductive compound and secured in place with screws or bolts extending into the side walls 105a-d.

The use of liquid cooling allows for more efficient cooling compared to natural or forced convection air cooling. Liquid cooling also significantly reduces thermal resistance within the system, enhancing heat transfer from the heat sources to the liquid coolant.

The first and second helical cooling channels 107, 111 may be independent and isolated channels, each with its own inlet and outlet, thereby providing redundancy in the cooling module 100. Having the inlets of each channel on opposing faces improves heat spreading and temperature distribution within the cooling module 100. As shown in FIG. 2, the two channels 107, 111 run parallel to each other, alternating in sequence, with both channels collectively providing cooling for the inductor core and windings as well as the semiconductor devices attached to the outer sides of the module 100. Providing coolant flow within the channels in opposing directions (i.e. one flow being clockwise while other is counterclockwise) not only enhances heat dissipation but further assists in the uniform temperature distribution because heat is dissipated in two directions (as heat flow) instead of just one.

As shown in FIG. 2, the helical cooling channels 107, 111 comprise straight paths extending across each side wall of the module 100 at a gradient, the straight paths connecting each other at corners of the module 100. The straight paths used for the channels 107, 111 reduce manufacturing costs and make fabrication easier. Each channel follows a gradient, followed by a 90-degree turn, and then followed by a similar gradient, the pattern repeating until the outlet is reached. The angle of each straight path to the faces and the channel diameter D₁ may be selected to incorporate as many channels as possible in the module 100, so as to better absorb and remove the heat generated. An inductor located within the central bore 112 is essentially surrounded by cooling channels, thereby ensuring a uniform temperature distribution and heat dissipation from the inductor components. This improves the space utilization as the thermal system is tightly constrained within the aluminium casing itself. No external cold plate or heat sinks need to be utilized, thereby making the system more compact. Additionally, wrapping the inductor heat source with cooling channels provides cooling at every angle (and not on a particular plane), thus reducing the chances of hot spots developing and promoting uniform temperature distribution within the system.

In addition to the helical cooling channel shape, an additional parallel cooling channel 108 may be provided, as shown in FIG. 2. The parallel cooling channel 108 extends from the first cooling liquid outlet 104 across one of the side walls 105a-d and connects to the helical cooling channel 107 at an opposing end of the side wall. A similar parallel cooling channel may be provided for the second helical cooling channel 111. A diameter D₂ of the parallel cooling channel 108 may be smaller than a diameter D₁ of the first helical cooling channel 107, as a smaller amount of cooling is required compared to the main helical path.

A gap 201 between the main helical cooling channel 107 and the parallel cooling channel 108 provides space to allow for screws or bolts to secure the semiconductor switching devices 106₁₋₆ to the side walls 105a-d of the module 100.

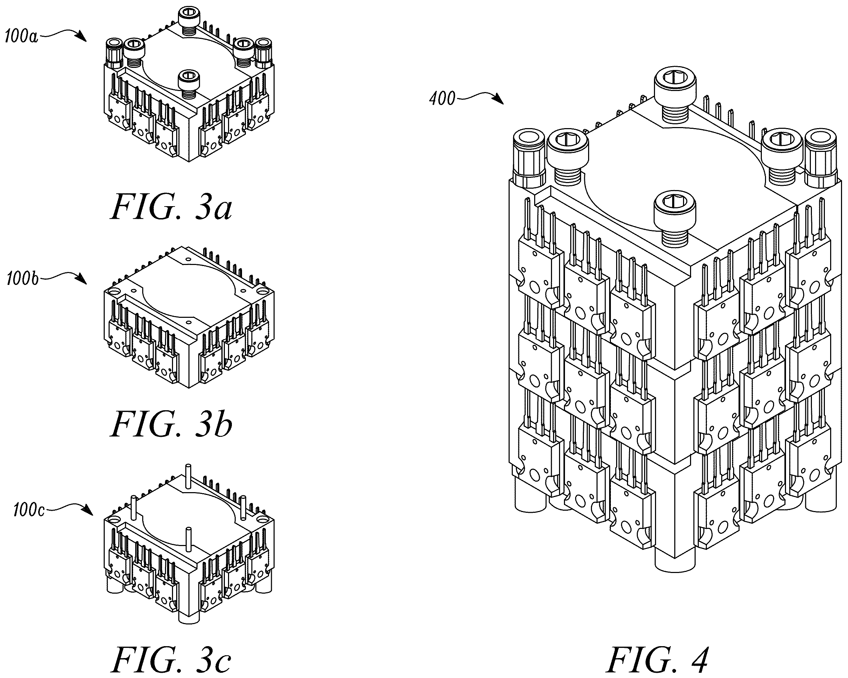

As illustrated in FIGs. 3a-3c and 4, a further feature of the cooling module design is in its modularity. In this example, three cooling modules 100a-c of similar construction can be assembled into a modular cooling assembly 400 such that a combined helical cooling channel extends through each of the helical liquid cooling channels of the cooling modules 100a-c. Each module 100a-c may for example comprise components for one phase of a three-phase converter assembly. Assembling a three-phase converter in this way can help gate drive symmetry due to the use of common cooling passageways through the modular cooling assembly 400.

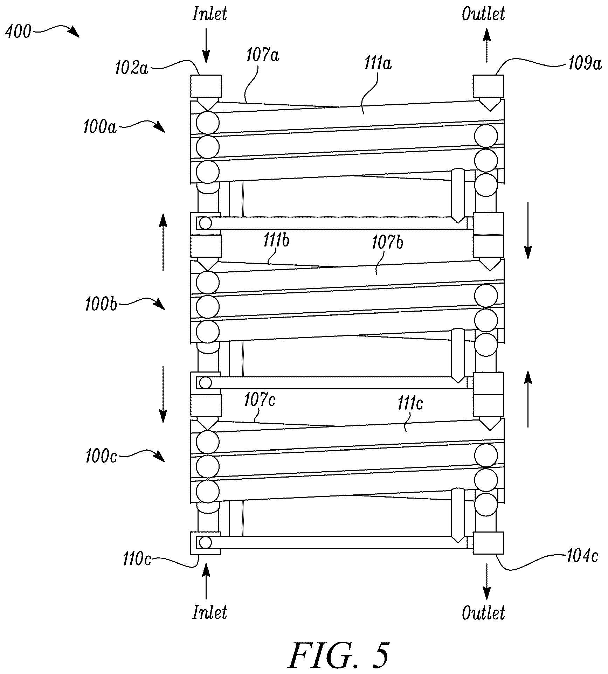

Although some features between modules can vary, such as cooling and attachment points, inlet and outlet fittings, the core structure of each cooling module remains the same. By stacking multiple cooling modules, the inlet and outlet of the channels also interconnect, with the outlet of one module attaching to the inlet of the next module. With each cooling module comprising first and second helical cooling channels 107a-c, 111a-c, the modular cooling assembly 400 comprises two longer channels, each with its own inlet and outlet, thus still a total of two inlets and outlets, as illustrated in FIG. 5. In this example, a first cooling liquid inlet 102a of a first cooling module 100a provides a first liquid cooling inlet of the cooling assembly 400 and a first cooling liquid outlet 104c of a third cooling module 100c provides a first liquid cooling outlet of the cooling assembly 400. Similarly, a second liquid cooling inlet 110c of the third cooling module 100c provides a second liquid cooling inlet of the cooling assembly 400 and a second liquid cooling outlet 109a of the first cooling module 100a provides a second liquid cooling outlet of the cooling assembly 400.

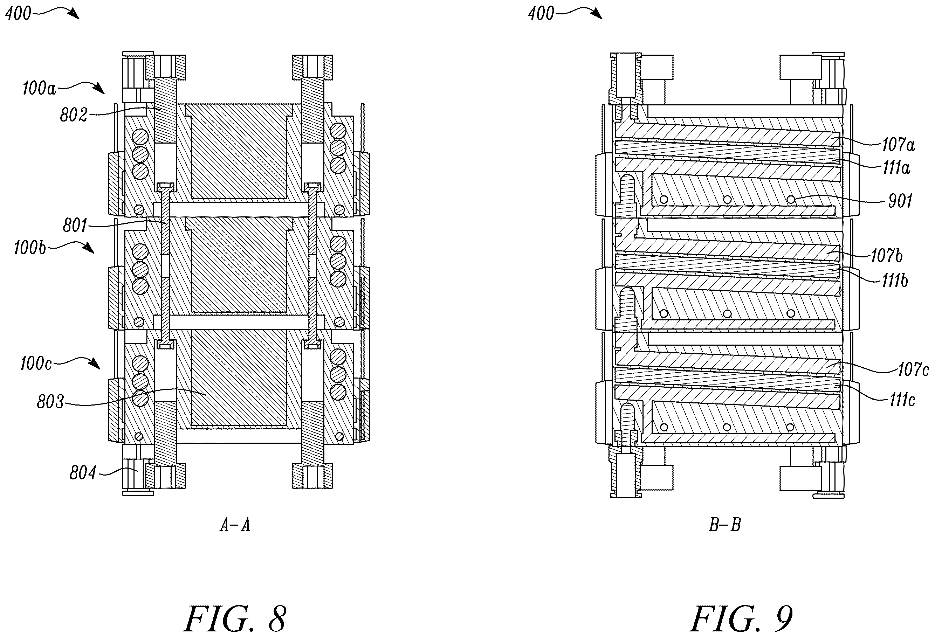

The modular construction allows for easy scalability, in which separate cooling modules 100a-c can be mechanically connected to each other, for example via screws or bolts passing through the modules, as shown in FIG. 8, or through other mechanisms. Appropriate cooling holes can be drilled into the aluminium casing as there is enough volumetric space available for these features.

To scale even further, multiple such stacks can be bundled together into a high-density volume and packaged together. A regular rectangular shape of each cooling module aids in optimising packing density of multiple cooling assemblies. While stacking multiple cooling modules optimizes space usage vertically, using multiple stacks further optimizes space usage horizontally.

The design of the module may be customizable according to particular requirements. The examples described herein show two helical cooling channels, but this may be increased further depending on requirements and available space, for example increasing the number of channels to four, with a total of four inlets and four outlets for each cooling module, which may be accommodated in a rectangular shape cooling module with inlets and outlets at each corner. The channel diameters and channel gradients may be adjusted accordingly to optimise usage of material and cooling. An advantage of adding more channels is in the improvement of thermal performance of the system itself, which may use higher flow rates without a significant increase in pressure drops.

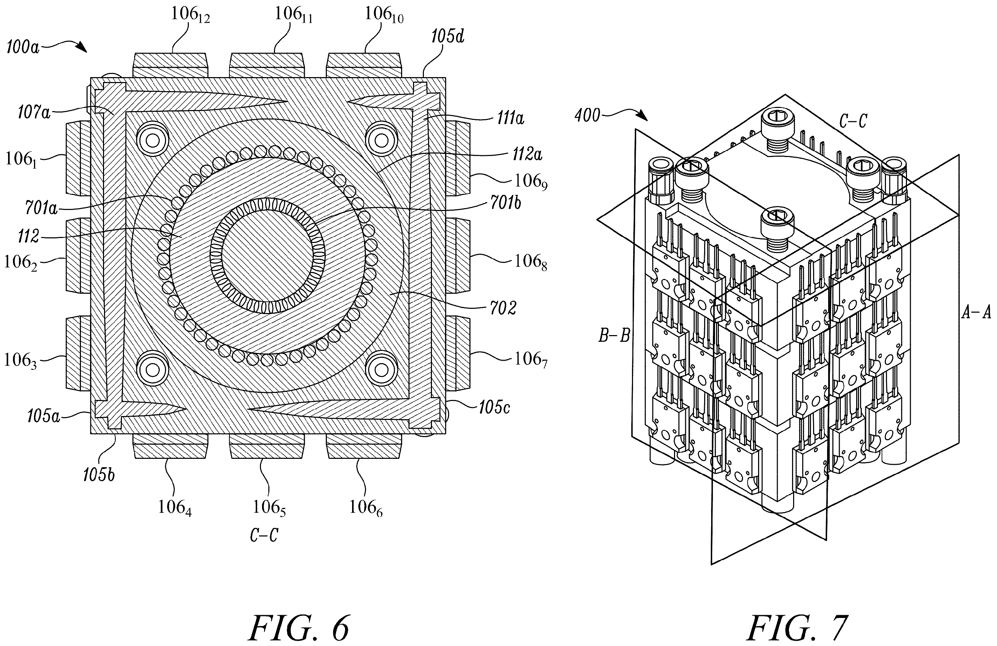

FIG. 6 illustrates a view of the example module cooling assembly 400 of FIG. 4, indicating vertical sections A-A and B-B and horizontal section C-C taken through the assembly 400. Sectional views are illustrated in FIGs. 7, 8 and 9, with FIG. 7 showing section C-C through one of the cooling modules 100a of the assembly, FIG. 8 a first vertical section A-A through the assembly 400 and FIG. 9 a second vertical section B-B through the assembly 400.

The section C-C through the cooling assembly 400 shown in FIG. 7 illustrates semiconductor switches 106₁₋₁₂ attached to each of the four side walls 105a-d of the cooling module 100a. First and second helical cooling channels 107a, 111a are shown extending across each of the side walls 105a-d to extract heat from the semiconductor switches 106₁₋₁₂ mounted to the side walls 105a-d. FIG. 7 also shows inductor components 701a, 701b embedded within the central bore 112a of the cooling module 100a. The helical cooling channels 106a, 111a also extract heat from the inductor components 701a, 701b. Further cooling may also be provided by a central cooling channel 702 passing through the central bore 112a.

FIG. 8 illustrates section A-A through the cooling assembly 400, showing in particular an example arrangement for connecting the cooling modules 100a-c together. The cooling modules 100a-c are connected together with bolts 801 in this example passing through first and third cooling modules 100a, 100c and securing the second cooling module 100b to the first and third cooling modules 100a, 100c on either side. Larger bolts 802 allow the first and third cooling modules 100a, 100c to be secured in position within a larger assembly. A portion of the central bore 803 is filled with a conductive resin to encase inductor components of the power electronics converter. Pipe fittings 804 allow connections to be made to the liquid inlets and outlets of the assembly 400.

FIG. 9 illustrates section B-B through the cooling assembly 400, showing in particular mounting holes 901 for mounting semiconductor switches to each of the walls of the cooling modules 100a-c such that a heat generating portion of each semiconductor switch is positioned over the cooling channels 107a-c, 111a-c of each of the cooling modules 100a-c.

Improving the space utilization of the system reduces the extent of materials utilized, giving substantial weight advantages, and thus enhancing power density significantly. Furthermore, the converter power density can be increased by increasing the current density and reducing the number of devices paralleled due to more efficient cooling.

Unlike traditional cold-plate based thermal management where hot spots may arise based on the orientation of the inductor on the cold plate, the proposed arrangement provides cooling to a centrally mounted inductor from all surrounding sides, achieving a more uniform temperature distribution across the components. This also enhances and provides a more uniform electrical performance of the inductor itself, potentially resulting in lower eddy current losses.

The design can be scaled up for high power applications through stacking of modules to improve power handling capacity. This may be particularly applicable for DC:DC converters, which can be designed as interleaved converters for which modularity is suitable.

In use, a wide variety of liquid coolants may be used due to the cooling channels being isolated. Different channels may also use different coolants based on the heat distribution of various modules.

The number of modules in each stack and the number of stacks in each bundle may be highly customizable based on requirements.

The channel diameters, number of isolated channels, cooling positions for semiconductor devices, size or scaling of each component can all be customized as per requirements.

The shape of the channel across each side wall may be straight but can be curved depending on manufacturing feasibility.

Valves may be provided between channels to create more complex or adaptive flow paths based on heat distribution of components. This can be used to circulate more coolant in certain modules as needed.

Various examples have been described, each of which comprise one or more combinations of features. It will be appreciated by those skilled in the art that, except where clearly mutually exclusive, any of the features may be employed separately or in combination with any other features and the invention extends to and includes all combinations and sub-combinations of one or more features described herein.

## Claims

1. A cooling module (100) for a power electronics converter, comprising:
a first face (101) having a cooling liquid inlet (102);
an opposing second face (103) having a cooling liquid outlet (104);
a plurality of side walls (105a-d) extending between the first and second faces (101, 103), each side wall (105a-d) being configured for cooling a semiconductor switching device (106₁₋₆) of the power electronics converter; and
a helical cooling channel (107) extending through the cooling module between the cooling liquid inlet (102) and the cooling liquid outlet (104) and , wherein the helical cooling channel is a first helical cooling channel (107), the cooling liquid inlet is a first cooling liquid inlet (102) and the cooling liquid outlet is a first cooling liquid outlet (104), the first face (101) comprising a second cooling liquid outlet (109), the second face (103) comprising a second cooling liquid inlet (110), the cooling module (100) comprising a second helical cooling channel (111) extending through the cooling module (100) between the second cooling liquid inlet (110) and the second cooling liquid outlet (109).

2. The cooling module (100) of claim 1, wherein the helical cooling channel (107) passes along each of the plurality of side walls (105a-d).

3. The cooling module (100) of claim 1 or claim 2, comprising a parallel cooling channel (108) extending from the cooling liquid outlet (104) across one of the plurality of side walls (105a-d) and connecting to the helical cooling channel (107).

4. The cooling module (100) of claim 3, wherein a diameter (D₂) of the parallel cooling channel (108) is smaller than a diameter (D₁) of the helical cooling channel (107).

5. The cooling module (100) of claim 1, wherein the first and second helical cooling channels (107, 111) each pass along each of the plurality of side walls (105a-d).

6. The cooling module (100) of claim 1 or claim 5, wherein the first liquid cooling inlet (102) is at an opposing corner of the first face (101) to the second liquid cooling outlet (109) and the first liquid cooling outlet (104) is at an opposing corner of the second face (103) to the second liquid cooling inlet (110).

7. The cooling module (100) of any preceding claim, wherein the first and second faces (101, 103) are generally rectangular in shape and the cooling module (100) comprises four side walls (105a-d).

8. The cooling module (100) of any preceding claim comprising a central bore (112) between the first and second faces (101, 103) for cooling an inductor of the power electronics converter.

9. The cooling module (100) of claim 8, further comprising a central cooling channel (702) passing through the central bore (112a).

10. The cooling module (100) of any preceding claim, wherein the cooling module (100) is composed of an aluminium alloy.

11. A modular cooling assembly (400) for a power electronics converter, the modular cooling assembly (400) comprising a plurality of cooling modules (100a-c) according to any preceding claim connected together such that a combined helical liquid cooling channel extends through each of the helical liquid cooling channels (107, 111) of the plurality of cooling modules (100a-c).

12. A power electronics converter assembly (100) comprising:
a cooling module (100) according to any one of claims 1 to 8; and
one or more semiconductor switches (106₁₋₆) mounted to each of the plurality of side walls (105a-d) of the cooling module (100).

13. The power electronics converter assembly (100) of claim 12, wherein the cooling module comprises a central bore (111) between the first and second faces (101, 103), the assembly (100) comprising inductor components (701a, 701b) mounted within the central bore (112).

14. The power electronics converter assembly (100) of claim 13, wherein the cooling module (100) comprises a central cooling channel (702) passing through the central bore (112a).
